Europäisches Patentamt

European Patent Office

Office européen des brevets

(19)

(11) Veröffentlichungsnummer: **0 227 171 B1**

# EUROPÄISCHE PATENTSCHRIFT

(45) Veröffentlichungstag der Patentschrift: **27.03.91**

(21) Anmeldenummer: **86202221.7**

(22) Anmeldetag: **10.12.86**

(51) Int. Cl.⁵: **H04N 9/44**, H04N 5/76, H03L 7/08

(54) **Schaltungsanordnung für einen Farbfernsehempfänger oder für ein Bildaufzeichnungs- und -wiedergabegerät zur Steuerung eines Oszillators.**

(30) Priorität: **18.12.85 DE 3544675**

(43) Veröffentlichungstag der Anmeldung:
**01.07.87 Patentblatt 87/27**

(45) Bekanntmachung des Hinweises auf die Patenterteilung:
**27.03.91 Patentblatt 91/13**

(84) Benannte Vertragsstaaten:
**AT DE FR GB NL**

(56) Entgegenhaltungen:
**EP-A- 0 115 234**
**DE-A- 3 044 835**
**DE-A- 3 122 811**

(73) Patentinhaber: **Philips Patentverwaltung GmbH**
**Wendenstrasse 35 Postfach 10 51 49**
**W-2000 Hamburg 1(DE)DE**

Patentinhaber: **N.V. Philips' Gloeilampenfabrieken**
**Groenewoudseweg 1**
**NL-5621 BA Eindhoven(NL)FR GB NL AT**

(72) Erfinder: **Matthies, Karl-Heinz**
**Tarfenböom 14 g**
**W-2000 Hamburg 62(DE)**

(74) Vertreter: **Hartmann, Heinrich, Dipl.-Ing. et al**
**Philips Patentverwaltung GmbH Wendenstrasse 35 Postfach 10 51 49**
**W-2000 Hamburg 1(DE)**

## Beschreibung

Die Erfindung bezieht sich auf eine Schaltungsanordnung für einen Farbfernsehempfänger oder für ein Bildaufzeichnungs-und/oder - wiedergabegerät zur Steuerung der Frequenz eines Oszillators, mit einer ersten Phasenvergleichsschaltung, die einen ersten Eingang zum Empfangen eines Farbsynchronsignals, einem zweiten Eingang zum Empfangen eines ersten Oszillatorsignals von einem mit diesem Eingang gekoppelten Referenzoszillator enthält und welche eingerichtet ist zum Abgeben eines ersten Ausgangssignals an ihrem Ausgang in Abhängigkeit von der Phasenabweichung zwischen dem Farbsynchronsignal und dem ersten Oszillatorsignal, mit einer Korrekturschaltung zum Erzeugen eines in der Amplitude begrenzten Korrektursignals und mit einer Signalkombinationsschaltung zum Überlagern des ersten Ausgangssignals mit dem Korrektursignal und zum daraus Ableiten eines Steuersignals zur Steuerung des Oszillators, wobei das Steuersignal weitgehend unabhängig von den durch die von Zeile zu Zeile vorkommenden Phasenwechsel des Farbsynchronsignals verursachten Schwankungen ist,

Eine solche Schaltungsanordnung ist aus der DE-A1 32 02 210 bekannt. In dieser Patentschrift wird eine Vorrichtung zur Verarbeitung eines PAL-Fernsehsignals beschrieben, bei der an einer Phasenvergleichsschaltung einerseits ein von einem Referenzoszillator erzeugtes Oszillatorsignal und andererseits ein auf eine Frequenz von 4,43 MHz moduliertes Farbartsignal anliegt. Das Farbartsignal enthält das während der Zeilenhinlaufzeit auftretende Farbsignal und das während eines Teiles der Zeilenrücklaufzeit auftretende Farbsynchronsignal. Der Phasenvergleich wird während der Zeit vorgenommen, in der das Farbsynchronsignal auftritt. Das Ausgangssignal der Phasenvergleichsschaltung wird einem Addierer zugeführt, dessen Ausgang mit einem Tiefpaß verbunden ist. Der Tiefpaß leitet ein Steuersignal einem Oszillator zu.

Da bei den PAL-Systemen die Phase des Farbsynchronsignals von Zeile zu Zeile um 90° wechselt, springt auch das Ausgangssignal der Phasenvergleichsschaltung mit der halben Zeilenfrequenz. Damit dieses wechselnde Signal nicht auf den frequenzabhänigen Oszillator einwirkt und somit Farbveränderungen verursacht, ist in der bekannten Schaltungsanordnung eine Korrekturschaltung vorgesehen, die ein Korrektursignal erzeugt, das zum Ausgangssignal der Phasenvergleichsschaltung addiert wird, so daß die durch das wechselnde Signal bedingte Störung weitgehend eliminiert wird. Die Korrekturschaltung umfaßt eine Schaltung, die mit halber Zeilenfrequenz auftretende Impulse erzeugt. Diese werden über eine Phasenumkehrstufe einer Stromquelle zur Erzeugung eines Gleichstroms zugeführt, der im Addierer mit der Phasenvergleichsschaltung überlagert wird.

Um sicherzustellen, daß ein dem Anteil des wechselnden Signals im Ausgangssignal der Phasenvergleichsschaltung entgegengesetztes Signal zugeführt wird, ist in der Korrekturschaltung der Ausgang des Tiefpasses über einen Hochpaß, einen Halbwellengleichrichter und einen Impulsformer mit einem Impulszähler gekoppelt, der die Impulse im Ausgangssignal des Tiefpasses zählt. Nach der Zählung von vier Impulsen verändert der Impulszähler den Zustand eines die Phasenumkehrstufe umschaltenden Kippgliedes. Die der Stromquelle zugeführten halbzeilenfrequenten Impulse werden invertiert.

Die bekannte Schaltungsanordnung ist sehr kompliziert aufgebaut und reagiert langsam bei fehlerhaften Umschaltphasenlagen, die z.B. bei der Wiedergabe von einem Bildaufzeichnungs-und - wiedergabegerät auftreten (z.B. Bildbetrachtung bei schnellen Vorlauf). Hierbei ist das Farbsynchronsignal nicht in seiner Phase von einer Zeile zur nächsten um 90° umgeschaltet worden. Bei einer solchen fehlerhaften Umschaltphasenlage vergehen zumindest 8 Zeilenperioden, bevor die bekannte Schaltungsanordnung diese Störung korrigiert und damit die Farbabweichungen beseitigt werden können.

Der Erfindung liegt die Aufgabe zugrunde, eine Schaltungsanordnung der eingangs genannten Art so auszubilden, daß die Regelung schneller erfolgt.

Diese Aufgabe wird erfindungsgemäß dadurch gelöst, daß die Korrekturschaltung zum Invertieren des ersten Ausgangssignals einen Inverter enthält, dessen Eingang mit dem Ausgang der Phasenvergleichsschaltung und dessen Ausgang mit einem Amplitudenbegrenzer gekoppelt ist, und daß weiter eine Detektionsschaltung vorgesehen ist zum Abschalten der Korrekturschaltung, wenn der Betrag der Phasenabweichung einen vorgebbaren Grenzwert überschreitet.

In der erfindungsgemäßen Schaltungsanordnung wird in der Korrekturschaltung ein Signal erzeugt, daß gegenüber dem ersten Ausgangssignal der ersten Phasenvergleichsschaltung invertiert ist. Es wird hierbei nicht wie bei der bekannten, komplizierten Schaltungsanordnung aus dem Steuersignal ein Korrektursignal gewonnen, sondern ein invertiertes erstes Ausgangssignal vor der Überlagerung gebildet. Eine Phasenabweichung, deren Betrag einen bestimmten Grenzwert überschreitet, wird in der Detektionsschaltung entdeckt und bewirkt eine Abschaltung der Korrekturschaltung. Das Steuersignal für den Oszillator besteht dann aus dem ersten Ausgangssignal der ersten Phasenvergleichsschaltung. Durch diese Abschaltung wird die Amplitude des Steuersignals vergrößert und somit wird die Regelgeschwindigkeit bei Verwendung der erfindungsgemäßen Schaltungsanordnung in einem Phasenregelkreis erhöht.

Es sei erwähnt, daß aus der DE-A1-3l 22 8ll eine Schaltungsanordnung bekannt ist, die beispielsweise zur Takt-Extraktion nach dem Empfang von übertragenen, digitalen Daten in Fernmeldeübertragungssystemen dient. Hierzu wird ein Phasenregelkreis verwendet, der eine Phasenvergleichsschaltung enthält, die aus dem Datensignal und einem von einem Oszillator erzeugten Referenzsignal ein Ausgangssignal bildet, welches einer Korrekturschaltung zugeführt wird. Die Korrekturschaltung führt das Ausgangssignal der Phasenvergleichsschaltung über einen Tiefpaß dem Oszillator zu. Falls Störimpulse auftreten, gibt die Korrekturschaltung ein invertiertes Ausgangssignal der Phasenvergleichsschaltung an den Tiefpaß weiter, d.h., wenn der Betrag des Ausgangssignals der Phasenvergleichsschaltung einen vorgegebenen Wert überschreitet. Hiermit wird der Fangbereich des Phasenregelkreises vergrößert.

In der erfindungsgemäßen Schaltungsanordnung wird das invertierte und das nichtinvertierte Ausgangssignal der Phasenvergleichsschaltung nur dann überlagert, wenn der Betrag des Ausgangssignals der Phasenvergleichsschaltung unterhalb eines vorgegebenen Grenzwertes liegt. Bei der bekannten Schaltungsanordnung aus der DE-OS 3l 22 8ll wird das nichtinvertierte Ausgangssignal der Phasenvergleichsschaltung durch das invertierte Ausgangssignal der Phasenvergleichsschaltung ersetzt, wenn der Betrag des Ausgangssignals der Phasenvergleichsschaltung einen vorgegebenen Wert überschreitet. In der bekannten Schaltungsanordnung wird also ein prinzipiell anderes Steuersignal gebildet.

Die Korrekturschaltung kann so ausgebildet werden, daß sie einen das erste Ausgangssignal invertierenden Inverter und einen das invertierte erste Ausgangssignal in der Amplitude begrenzenden und das Korrektursignal bildenden Amplitudenbegrenzer enthält. Das invertierte erste Ausgangssignal kann auch mit Hilfe einer weiteren Phasenvergleichsschaltung erzeugt werden, indem diese das Synchronisiersignal mit einem weiteren von dem Referenzoszillator erzeugten Oszillatorsignal vergleicht, das eine bestimmte Phasenabweichung zum ersten Oszillatorsignal aufweist. Am Ausgang dieser Phasenvergleichsschaltung erscheint dann ein dem invertierten ersten Ausgangssignal identisches Signal.

Der Amplitudenbegrenzer kann nun so eingestellt werden, daß bei einer Phasenabweichung die Amplitude des vom Amplitudenbegrenzers gelieferten Korrektursignals nicht größer als die Amplitude des Ausgangssignals des Inverters ist, wenn keine Phasenabweichung vorliegt. Durch diese Schaltungsmaßnahme ist gewährleistet, daß das Korrektursignal nur die von den Phasenwechseln des Farbsynchronsignals verursachten Schwankungen auslöscht. Die Anteile im Steuersignal, die die Phasenabweichung bestimmen, werden dagegen nicht beeinflußt.

Die Detektionsschaltung kann so ausgebildet sein, daß sie eine in Abhängigkeit von dem Farbsynchronsignal und einem in dem Referenzoszillator erzeugten zweiten Oszillatorsignal, das einen festen Phasenunterschied gegenüber dem ersten aufweist, ein zweites Ausgangssignal erzeugende Phasenvergleichsschaltung und einen Schwellwertdetektor enthält, von dem ein Abschaltsignal zum Abschalten der Korrekturschaltung abgeleitet wird, wenn der Betrag der Phasenabweichung einen vorgebbaren Grenzwert überschreitet. Das zweite Oszillatorsignal muß gegenüber dem ersten einen solchen Phasenunterschied aufweisen, daß der Schwellwertdetektor nur bei bestimmten Phasenabweichungen ein Signal erzeugt, aus dem das Abschaltsignal für die Korrekturschaltung abgeleitet wird. Beispielsweise kann zwischen dem ersten und zweiten Oszillatorsignal ein Phasenunterschied von 90° bestehen. Durch die Abschaltung der Korrekturschaltung bildet das erste Ausgangssignal das Steuersignal für den frequenzabhängigen Oszillator.

Die Detektionsschaltung kann so ausgebildet werden, daß der Ausgang des Schwellwertdetektors mit dem Setzeingang eines das Abschaltsignal erzeugenden Kippgliedes verbunden ist.

Weiterhin ist vorgesehen, daß der Ausgang der zweiten Phasenvergleichsschaltung mit einem Farbabschalter gekoppelt ist.

Anhand der Zeichnungen wird im folgenden die Erfindung näher erläutert. Es zeigt:

Fig. l einen Teil einer Videorecorderschaltung mit der erfindungsgemäßen Schaltungsanordnung,

Fig. 2 ein Ausführungsbeispiel der Erfindung und

Fig. 3 Diagramme zur Erläuterung der Fig. 2.

Eine Schaltungsanordnung für einen Videorecorder nach der VHS-PAL-Norm ist in Fig. l dargestellt. Dem Eingang l eines Modulators 2 wird ein über die Videoköpfe wiedergegebenes und in einem Tiefpaß mit der Grenzfrequenz von l,l MHz bandbegrenztes Farbartsignal, das mit einem ersten Träger von 627 kHz moduliert ist, zugeführt. Im Modulator 2 wird das Farbartsignal von dem ersten Träger mit einer Frequenz von 627 kHz auf einen zweiten Träger mit einer Frequenz von 4,43 MHz moduliert. Für diesen Umsetzungsprozeß wird einem zweiten Eingang 3 des Modulators 2 ein dritter Träger von 5,06 MHz zugeführt. Das am Ausgang 4 des Modulators 2 liegende Modulationsprodukt enthält das um den Träger mit einer Frequenz von 4,43 MHz liegende Farbartsignal und einen höherfrequenten Signalanteil, der im nachgeschalteten Bandpaß 5 mit einer Mittenfrequenz von 4,43 MHz unterdrückt wird. Das Ausgangssignal des Bandpasses 5, das auch das Ausgangssignal der Schaltungsanordnung ist, wird einem Schalter 6 zugeleitet. Der Ausgang 19 des Schalters 6 ist mit der erfindungsgemäßen Schaltungsanordnung 7 verbunden. Der Schalter 6 ist während der Farbsynchronaustastzeit geschlossen, d.h. während der Zeit, in der das Farbsynchronsignal vorliegt.

Das Ausgangssignal des Schalters 6 wird in der Schaltung 7 einer Schaltung 8 zugeführt, die einen ersten Phasenvergleicher, eine Korrekturschaltung und eine Detektionsschaltung enthält. Der Schaltung 8 wird noch ein erstes quarzstabiles Oszillatorsignal mit einer Frequenz von 4,43 MHz und ein zweites Oszillatorsignal mit derselben Frequenz, aber gegenüber dem ersten um $90°$ in der Phase verschoben, von einem Referenzoszillator 9 zugeführt. Das Ausgangssignal der Schaltung 8 wird über einen Tiefpaß 10, der ebenso wie der Referenzoszillator 9 Teil der Schaltung 7 ist, einem spannungsgesteuerten Oszillator 11 als Steuersignal zugeleitet.

Der Oszillator 11, der ein weiteres Oszillatorsignal mit einer Frequenz von 5,016 MHz liefert, wird in der Phase von der Schaltung 7 gesteuert. Um zu verhindern, daß der Oszillator bei einer Frequenz einrastet, die nicht der gewünschten Frequenz entspricht, ist ein Nebeneinfangdetektor 12 vorgesehen, der den spannungsgesteuerten Oszillator 11 in der Nähe der Frequenz von 5,016 MHz hält. Das Prinzip des Nebeneinfangdetektors ist z.B. in der DE-A1-32 02 210 beschrieben.

Der Ausgang des Oszillators 11 ist mit einem Frequenzteiler 13 verbunden, der die Frequenz des Oszillatorsignals durch acht teilt. Am Ausgang des Frequenzteilers 13 liegt ein Signal mit einer Frequenz von 627 kHz vor, das einem ersten Eingang 14 eines Mischers 15 zugeführt wird. Dem anderen Eingang 16 des Mischers 15 wird ein Oszillatorsignal mit einer Frequenz von 4,43 MHz von dem Referenzoszillator 9 zugeleitet. Am Ausgang 17 des Mischers 15 ist ein Mischsignal mit den beiden Frequenzanteilen von 5,06 MHz und 3,86 MHz vorhanden. Dieses Mischsignal wird über einen Bandpaß 18, der den niederfrequenten Signalanteil unterdrückt, als dritter Träger dem Eingang 3 des Modulators 2 zugeführt.

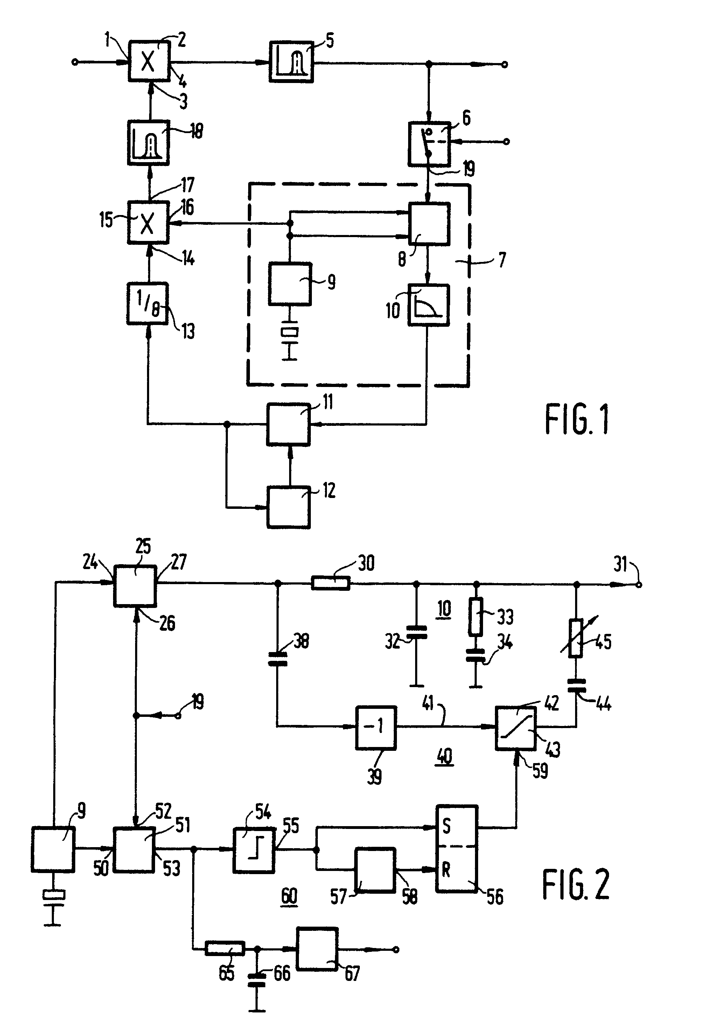

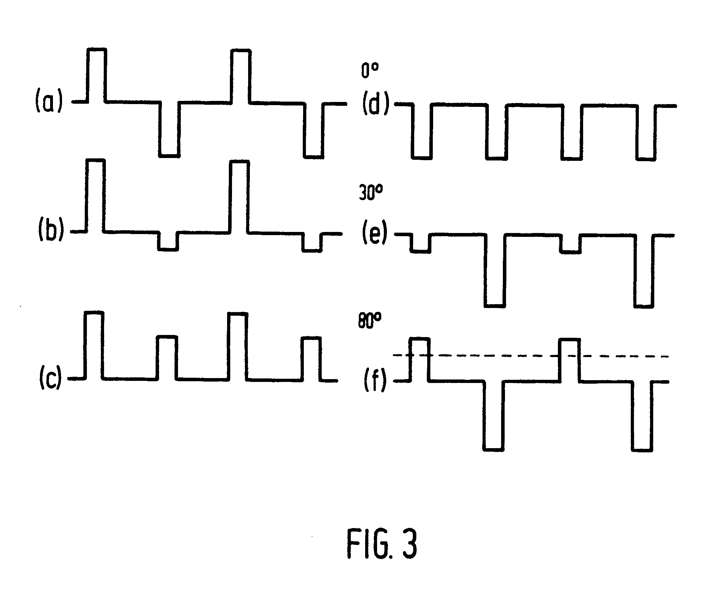

In Fig. 2 ist ein Ausführungsbeispiel der erfindungsgemäßen Schaltungsanordnung 7 dargestellt. Der Referenzoszillator 9 liefert das erste Oszillatorsignal mit einer Frequenz von 4,43 MHz, das einem ersten Eingang 24 einer ersten Phasenvergleichsschaltung 25 zugeführt wird, deren zweiter Eingang 26 das Farbsynchronsignal vom Anschluß 19 erhält. Die Phasenvergleichsschaltung 25 vergleicht das erste Oszillatorsignal und das Farbsynchronsignal in der Phase und liefert an einem Ausgang 27 ein der Phasenabweichung zwischen diesen beiden Signalen entsprechendes Ausgangssignal.

Das Ausgangssignal der Phasenvergleichsschaltung 25 wird über einen Widerstand 30 dem Ausgangsanschluß 31 zugeführt. An dem Ausgangsanschluß 31 ist ein Tiefpaß 10 angeschlossen, der eine Parallelschaltung aus einem Kondensator 32 und eine Reihenschaltung aus einem Widerstand 33 und einem Kondensator 34 enthält, die zwischen dem Ausgangsanschluß 31 und Masse geschaltet ist. Der Tiefpaß 10 dient zur Unterdrückung hochfrequenter Anteile im Signal, das dem Ausgangsanschluß 31 zugeführt wird. Der Ausgang 27 der Phasenvergleichsschaltung 25 ist noch über einen Kondensator 38 mit einem Inverter 39 verbunden, der Teil einer Korrekturschaltung 40 ist. Die Korrekturschaltung 40 enthält noch einen mit dem Ausgang 41 des Inverters 39 verbundenen Amplitudenbegrenzers 42, der das Ausgangssignal des Inverters 39 verstärkt und in seiner Amplitude begrenzt und dieses als Korrektursignal an seinem Ausgang 43 abgibt. Vom Ausgang 43 des Amplitudenbegrenzers 42 wird das Korrektursignal über einen Kondensator 44 und einen einstellbaren Widerstand 45 dem Ausgangsanschluß 31 zugeleitet und dem Ausgangssignal der Phasenvergleichsschaltung 25 überlagert.

Bei einem PAL-codierten Fernsehsignal wechselt die Phase des Farbsynchronsignals von Zeile zu Zeile um $90°$. Im Farbkreis liegen die Farbsynchronsignale einerseits bei $135°$ und andererseits bei $225°$ bezogen auf das Farbdifferenzsignal U. Im Ausgangssignal der ersten Phasenvergleichsschaltung ist daher bedingt durch die Phasenwechsel im Farbsynchronsignal ein Wechselsignal vorhanden, dessen Mittelwert gleich Null ist. In Fig. 3 ist z.B. in Diagramm a ein Ausgangssignal der Phasenvergleichsschaltung 25, wenn keine Phasenabweichung ($0°$) zwischen dem ersten Oszillatorsignal und dem Farbsynchronsignal auftritt, für vier aufeinanderfolgende Zeilen dargestellt. Mit Hilfe der Korrekturschaltung 40 wird nun ein Korrektursignal erzeugt, das gegenüber dem Ausgangssignal der Phasenvergleichsschaltung 25 invertiert ist und das Wechselsignal im Ausgangssignal der Phasenvergleichsschaltung am Ausgangsanschluß 31 auslöscht. Der Amplitudenbegrenzer ist dabei so eingestellt, daß er, wenn keine Phasenabweichung auftritt, genau das Wechselsignal auslöscht.

In dem vorliegenden Ausführungsbeispiel wird das Korrektursignal vom Ausgang 43 des Amplitudenbegrenzers 42 über einen Kondensator 44 und einem einstellbaren Widerstand 45 dem Ausgangsanschluß 31 zugeleitet. Der Kondensator 44 unterdrückt unerwünschte Gleichströme zwischen dem Ausgang 43 des Amplitudenbegrenzers 42 und dem Ausgang 27 der Phasenvergleichsschaltung 25. Mit dem einstellbaren Widerstand 45 kann die Amplitude des Korrektursignal justiert werden.

Der Referenzoszillator 9 liefert das zweite Oszillatorsignal, das gegenüber dem ersten Oszillatorsignal in der Phase um 90° verschoben ist, einem Eingang 50 einer zweiten Phasenvergleichsschaltung 5l, deren anderem Eingang 52 das Farbsynchronsignal vom Anschluß l9 zugeleitet wird. Am Ausgang 53 der Phasenvergleichsschaltung 5l steht ein Ausgangssignal zur Verfügung, das die Phasenabweichungzwischen dem zweiten Oszillatorsignal und dem Farbsynchronsignal angibt. In Diagramm d bis f der Fig. 3 sind verschiedene Ausgangssignale für vier aufeinanderfolgende Zeilen für eine Phasenabweichung von 0°, 30° und 80° gezeigt. In den Diagrammen a bis c der Fig. 3 sind die entsprechenden Ausgangssignale der Phasenvergleichsschaltung 25 aufgezeigt. Der Ausgang 53 der Phasenvergleichsschaltung 5l ist mit einem Schwellwertdetektor 54 verbunden, der einen Impuls erzeugt, wenn der Betrag der Phasenabweichung zwischen dem ersten Oszillatorsignal und dem Farbsynchronsignal einen bestimmten Wert, z.B. 70°, überschreitet. In diesem Fall ist während jeder zweiten Zeile der Wert des Ausgangssignals der Phasenvergleichsschaltung 5l größer als der Schwellwert. In Diagramm f der Fig. 3 ist erkennbar, daß jeder zweite Impuls den gestrichelt eingezeichneten Schwellwert für eine Phasenabweichung von 70° überschreitet.

Der Ausgang 55 des Schwellwertdetektors 54 ist einerseits mit einem Setzeingang eines RS-Kippgliedes 56 verbunden und andererseits mit einer Halteschaltung 57. Der Ausgang 58 der Halteschaltung 57 ist an den Rücksetzeingang eines RS-Kippgliedes angeschlossen. Die Halteschaltung 57 erzeugt nach dem Auftreten von zwei auf die Setzung des Kippgliedes 56 folgenden Farbsynchronsignalen ein Rücksetzsignal, wenn der Schwellwertdetektor 54 keinen weiteren Impuls erzeugt hat, d.h. wenn der Betrag der Phasenabweichung zwischen dem ersten Oszillatorsignal und dem Farbsynchronsignal geringer als 70° ist. Das Rücksetzsignal kann aber auch später erzeugt werden, z.B. nach vier darauffolgenden Zeilen. Die Phasenvergleichsschaltung 5l, der Schwellwertdetektor 54, die Halteschaltung 57 und das RS-Kippglied 56 bilden eine ein Abschaltsignal erzeugende Detektionsschaltung 60.

Das RS-Kippglied 56 leitet einem Eingang 59 des Amplitudenbegrenzers 42 das Abschaltsignal zu, nachdem es gesetzt worden ist. Das Abschaltsignal verhindert, daß der Amplitudenbegrenzer 42 ein Korrektursignal abgibt. Am Ausgangsanschluß 3l ist das Steuersignal dann identisch mit dem Ausgangssignal der Phasenvergleichsschaltung 25. Durch die Abschaltung des Korrektursignals wird die Amplitude des Steuersignals vergrößert, wie das auch aus dem Diagramm c der Fig. 3 ersichtlich ist und die Regelgeschwindigkeit z.B. in der Schaltungsanordnung nach Fig. l wird erhöht. Bei diesen großen Phasenabweichungen sind auch die Amplitudenunterschiede zwischen zwei aufeinanderfolgenden Zeilen im Ausgangssignal der Phasenvergleichsschaltung 25 geringer.

Der Ausgang 53 der Phasenvergleichsschaltung 5l ist noch mit einem Widerstand 65 verbunden, dessen anderer Anschluß an einem an Masse angeschlossenen Kondensator 66 liegt. An dem Verbindungspunkt zwischen Widerstand 65 und Kondensator 66 ist ein Farbabschalter 67 angeschlossen, der ein Farbabschaltsignal erzeugt. Der Widerstand 65 und der Kondensator 66 bilden einen Integrator, der eine große Zeitkonstante aufweist. Der Farbabschalter 67 detektiert in bekannter Weise das Ausgangssignal dieses Integrators und erzeugt bei einem bestimmten Pegel das Farbabschaltsignal, wodurch die Farbsignalwiedergabe verhindert wird.

## Ansprüche

1. Schaltungsanordnung für einen Farbfernsehempfänger oder für ein Bildaufzeichnungs- und/oder -wiedergabegerät zur Steuerung der Frequenz eines Oszillators, mit einer ersten Phasenvergleichsschaltung (25), die einen ersten Eingang (26) zum Empfangen eines Farbsynchronsignals, einem zweiten Eingang (24) zum Empfangen eines ersten Oszillatorsignals von einem mit diesem Eingang (24) gekoppelten Referenzoszillator (9) enthält und welche eingerichtet ist zum Abgeben eines ersten Ausgangssignals an ihrem Ausgang (27) in Abhängigkeit von der Phasenabweichung zwischen dem Farbsynchronsignal und dem ersten Oszillatorsignal, mit einer Korrekturschaltung (40) zum Erzeugen eines in der Amplitude begrenzten Korrektursignals und mit einer Signalkombinationsschaltung zum Überlagern des ersten Ausgangssignals mit dem Korrektursignal und zum daraus Ableiten eines Steuersignals zur Steuerung des Oszillators, wobei das Steuersignal weitgehend unabhängig von den durch die von Zeile zu Zeile vorkommenden Phasenwechsel des Farbsynchronsignals verursachten Schwankungen ist, dadurch gekennzeichnet , daß die Korrekturschaltung (40) zum Invertieren des ersten Ausgangssignals einen Inverter (39) enthält, dessen Eingang mit dem Ausgang (27) der Phasenvergleichsschaltung (25) und dessen Ausgang (4l) mit einem Amplitudenbegrenzer (42) gekoppelt ist, und daß weiter eine Detektionsschaltung (60) vorgesehen ist zum Abschalten der Korrekturschaltung (40), wenn der Betrag der Phasenabweichung einen vorgebbaren Grenzwert überschreitet.

2. Schaltungsanordnung nach Anspruch l, dadurch gekennzeichnet , daß bei einer Phasenabweichung die Amplitude des vom Amplitudenbegrenzers (42) gelieferten Korrektursignals nicht größer als die Amplitude des Ausgangssignals des Inverters (39) ist, wenn keine Phasenabweichung vorliegt.

3. Schaltungsanordnung nach Anspruch l oder 2, dadurch gekennzeichnet , daß die Detektionsschaltung (60) eine in Abhängigkeit von dem Farbsynchronsignal und einem in dem Referenzoszillator erzeugten zweiten Oszillatorsignal, das einen festen Phasenunterschied gegenüber dem ersten aufweist, ein zweites Ausgangssignal erzeugende Phasenvergleichsschaltung (5l) und einen Schwellwertdetektor (54) enthält, von dem ein Abschaltsignal zum Abschalten der Korrekturschaltung (40) abgeleitet wird, wenn der Betrag der Phasenabweichung einen vorgebbaren Grenzwert überschreitet.

4. Schaltungsanordnung nach Anspruch 3, dadurch gekennzeichnet , daß der Ausgang des Schwellwertdetektors (54) mit dem Setzeingang eines das Abschaltsignal erzeugenden Kippgliedes (56) verbunden ist.

5. Schaltungsanordnung nach Anspruch 3 oder 4, dadurch gekennzeichnet , daß der Ausgang der zweiten Phasenvergleichsschaltung (5l) mit einem Farbabschalter (67) gekoppelt ist.

**Claims**

1. A circuit arrangement for controlling the freguency of an oscillator in a colour television receiver or a video recording and/or reproducing apparatus, the arrangement comprising a phase-comparator circuit (25) having a first input (26) for receiving a burst signal, a second input (24) for receiving a first oscillator signal from a reference oscillator (9) coupled to said second input (24), which phase-comparator circuit is adapted to produce a first output signal on its output (27) depending on the phase difference between the colour burst signal and the first oscillator signal, a correction circuit (40) for generating an amplitude-limited correction signal, and a signal-combination circuit for superimposing the correction signal on the first output signal and for deriving therefrom a control signal for controlling the oscillator, the control signal being substantially independent of fluctuations as a result of the phase alternation of the burst signal every other line, characterized in that the correction circuit (40) comprises an inverter (39) having its input coupled to the output (27) of the phase-comparator circuit (25), for inverting the first output signal, and having its output (41) coupled to an amplitude limiter (42), and there is further provided a detection circuit (60) for disabling the correction circuit (40) when the magnitude of the phase difference exceeds a predetermined limit value.

2. A circuit arrangement as claimed in Claim 1, characterized in that the amplitude of the correction signal supplied by the amplitude limiter (42) in the case of a phase error does not exceed the amplitude of the output signal of the inverter (39) when there is no phase error.

3. A circuit arrangement as claimed in Claim 1 or 2, characterized in that the detection circuit (60) comprises a phase-comparator circuit (51) and a threshold detector (54), which phase-comparator circuit generates a second output signal depending on the burst signal and a second oscillator signal generated in the reference oscillator, which second oscillator signal has a fixed phase difference relative to the first oscillator signal, a disable signal for disabling the correction circuit (40) being derived by the threshold detector when the magnitude of the phase error exceeds a predetermined limit.

4. A circuit arrangement as claimed in Claim 3, characterized in that the output of the threshold detector (54) is connected to the set input of a multivibrator circuit (56) which generates the disable signal.

5. A circuit arrangement as claimed in Claim 3 or 4, characterized in that the output of the second phase-comparator circuit (51) is coupled to a colour killer (67).

**Revendications**

1. Circuit de commande pour un récepteur de télévision en couleur ou pour un appareil d'enregistrement et/ou de reproduction d'images destiné à commander la fréquence d'un oscillateur et présentant un premier circuit comparateur de phase (25) comportant une première entrée (26) pour la réception d'un signal de synchronisation de couleur, une deuxième entrée (24) pour la réception d'un premier signal d'oscillateur à partir d'un oscillateur de référence (9) couplé à ladite entrée (24) et agencé pour délivrer sur sa sortie (27) un premier signal de sortie en fonction de l'écart de phase entre le signal de synchronisation de couleur et le premier signal d'oscillateur, un circuit de correction (40) pour engendrer un signal de correction à amplitude limitée et un circuit combinateur de signaux pour superposer le signal de correction au premier signal de sortie et pour en déduire un signal de commande pour commander l'oscillateur, le signal de commande étant largement indépendant des variations provoquées par le changement de phase du signal de synchronisation de couleur, se produisant d'une ligne à l'autre, caractérisé en ce que, pour l'inversion du premier signal de sortie, le circuit de correction (40) comporte un inverseur (39) dont l'entrée est couplée à la sortie (27) du circuit comparateur de phase (25) et dont la sortie (41) est couplée à un limiteur d'amplitude (42) et en ce que l'on a prévu en outre un circuit de détection (60) pour mettre hors service le circuit de correction (40) si la valeur de l'écart de phase dépasse une valeur limite prédéterminée.

2. Circuit de commande selon la revendication 1, caractérisé en ce qu'en présence d'un écart de phase, l'amplitude du signal de correction délivré par le limiteur d'amplitude (42) n'est pas supérieure à l'amplitude du signal de sortie de l'inverseur (39) en l'absence d'un écart de phase.

3. Circuit selon la revendication 1 ou 2, caractérisé en ce que le circuit de détection (60) comporte, d'une part, un circuit comparateur de phase (51) qui, en fonction du signal de synchronisation de couleur et d'un deuxième signal d'oscillateur engendré dans l'oscillateur de référence et présentant une différence de phase fixe par rapport au premier signal d'oscillateur, engendre un deuxième signal de sortie et, d'autre part, un détecteur de valeur de seuil (54) d'où est déduit un signal pour mettre hors service le circuit de correction (40) si la valeur de l'écart de phase dépasse une valeur limite prédéterminée.

4. Circuit de commande selon la revendication 3, caractérisé en ce que la sortie du détecteur de valeur de seuil (54) est reliée à l'entrée d'activation d'une bascule (56) engendrant le signal pour mettre hors service le circuit de correction.

5. Circuit de commande selon la revendication 3 ou 4, caractérisé en ce que la sortie du deuxième circuit comparateur de phase (51) est couplée à un suppresseur de couleur (67).

FIG.1

FIG.2

FIG. 3